(19) Europäisches Patentamt
European Patent Office
Office européen des brevets

(11) **EP 2 657 997 A2**

(12) **EUROPEAN PATENT APPLICATION**

(43) Date of publication:
**30.10.2013 Bulletin 2013/44**

(51) Int Cl.:
***H01L 33/50*** *(2010.01)*

(21) Application number: **12182365.2**

(22) Date of filing: **30.08.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **27.04.2012 JP 2012103362**

(71) Applicant: **Kabushiki Kaisha Toshiba**
**Tokyo 105-8001 (JP)**

(72) Inventors:
• **Akimoto, Yosuke**
**Tokyo, 105-8001 (JP)**

• **Kojima, Akihiro**
**Tokyo, 105-8001 (JP)**
• **Shimada, Miyoko**
**Tokyo, 105-8001 (JP)**
• **Tomizawa, Hideyuki**
**Tokyo, 105-8001 (JP)**
• **Sugizaki, Yoshiaki**
**Tokyo, 105-8001 (JP)**
• **Furuyama, Hideto**
**Tokyo, 105-8001 (JP)**

(74) Representative: **HOFFMANN EITLE**
**Patent- und Rechtsanwälte**
**Arabellastrasse 4**
**81925 München (DE)**

(54) **Semiconductor light emitting device**

(57) According to an embodiment, a semiconductor light emitting device includes a semiconductor layer (15) including a light emitting layer (13) and a fluorescent substance (32) excited by light emitted from the light emitting layer (13), a peak wavelength of a radiation spectrum of the light emitting layer (13) at a room temperature being shorter than a peak wavelength of an excitation spectrum of the fluorescent substance (32).

FIG. 1

**Description**

FIELD

Embodiments are generally related to a semiconductor light emitting device.

BACKGROUND

Semiconductor light emitting devices that emit visible light such as white light or light of the other wavelength band will be widely used as small-sized and easily handled light sources. Such a device includes a semiconductor light emitting element and fluorescent substances, and emits light combining the radiations of the semiconductor light emitting element and the fluorescent substances.

However, the semiconductor light emitting element has the property that the radiation wavelength shifts depending on an operating temperature. The intensity of the radiation from the fluorescent substances excited by the radiation of the semiconductor light emitting element also varies due to the wavelength shift. As a result, the light emitted from the semiconductor light emitting device changes in the color rendering property and the light intensity. Thus, there is a requirement for the semiconductor light emitting device to suppress the changes of the light emitting characteristics depending on the operating temperature.

BRIEF DESCRIPTION OF THE DRAWINGS

FIG. 1 is a schematic cross-sectional view of a semiconductor light emitting device according to a first embodiment;
FIG. 2 is a graph showing a characteristic of a fluorescent substance according to the first embodiment;
FIG. 3 is a graph showing a characteristic of a fluorescent substance according to a variation of the first embodiment;
FIGS. 4A and 4B are graphs showing the light emitting characteristics of the semiconductor light emitting device according to the first embodiment;
FIGS. 5A to 16B are schematic views illustrating manufacturing process of the semiconductor light emitting device according to the first embodiment;
FIG. 17 is a schematic cross-sectional view of a semiconductor light emitting device according to a variation of the first embodiment;
FIG. 18 is a schematic cross-sectional view of a semiconductor light emitting device according to another variation of the first embodiment;
FIG. 19A to 19C are schematic views of a semiconductor light emitting device according to a second embodiment;
FIG. 20 is a schematic cross-sectional view of a light emitting module, in which the semiconductor light emitting device illustrated in FIG.19 is mounted on a mounting substrate;
FIGS. 21A and 21B are graphs showing characteristics of a fluorescent substance according to a third embodiment;
FIG. 22 is graph showing a characteristic of a fluorescent substance according to a comparative example; and
FIGS. 23A and 23B are graphs showing the light emitting characteristics of a semiconductor light emitting device according to the comparative example.

DETAILED DESCRIPTION

According to an embodiment, a semiconductor light emitting device includes a semiconductor layer including a light emitting layer and a fluorescent substance excited by light emitted from the light emitting layer, a peak wavelength of a radiation spectrum of the light emitting layer at a room temperature being shorter than a peak wavelength of an excitation spectrum of the fluorescent substance.

Hereinafter, embodiments will be described with reference to the drawings. Like reference numerals in the drawings denote like elements, and the descriptions of the like elements are appropriately omitted and the different elements are described.

First Embodiment

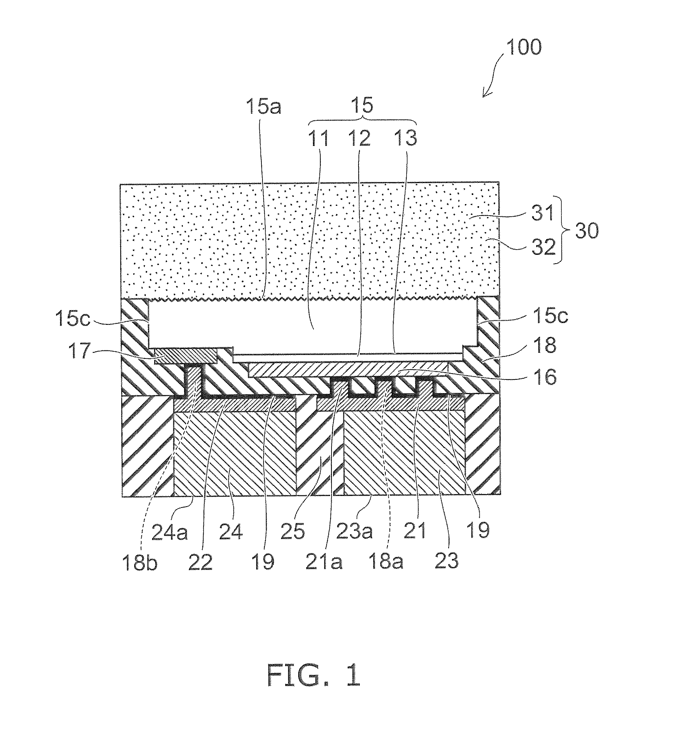

FIG. 1 is a schematic cross-sectional view of a semiconductor light emitting device 100 according to a first embodiment.

The semiconductor light emitting device 100 includes a semiconductor layer 15 that includes a light emitting layer 13. In addition, the semiconductor layer 15 has a first face 15a and a second face that is located on a side opposite to the first face 15a. On a second face side, electrodes and an interconnection part are provided, and light is emitted mainly to the outer side from the first face 15a on which the electrodes and the interconnection part are not provided.

The semiconductor layer 15 includes a first semiconductor layer 11 and a second semiconductor layer 12. The first semiconductor layer 11 and the second semiconductor layer 12, for example, contain gallium nitride. The first semiconductor layer 11 may include an underlying buffer layer, an n-type GaN layer, and the like. The second semiconductor layer 12 includes a p-type GaN layer, a light emitting layer (active layer) 13, and the like. The light emitting layer 13 may include a material that emits blue light, purple light, blue-purple light, ultraviolet light, or the like.

The second face of the semiconductor layer 15 is formed in a concavo-convex shape, and a convex part includes the light emitting layer 13. A p-side electrode 16 is provided on the surface of the second semiconductor layer 12, which is the surface of the convex part. In other words, the p-side electrode 16 is provided on a first region of the second face that is the top surface of the convex part of the semiconductor layer 15.

In the semiconductor layer 15, a part that does not include the light emitting layer 13 is provided on a side of the convex part, where the light emitting layer 13 is removed and a surface of the first semiconductor layer 11 is exposed. An n-side electrode 17 is provided on the exposed surface of the first semiconductor layer 11. In other words, the n-side electrode 17 is provided in a second region of the second surface that is the surface of the part not including the light emitting layer 13.

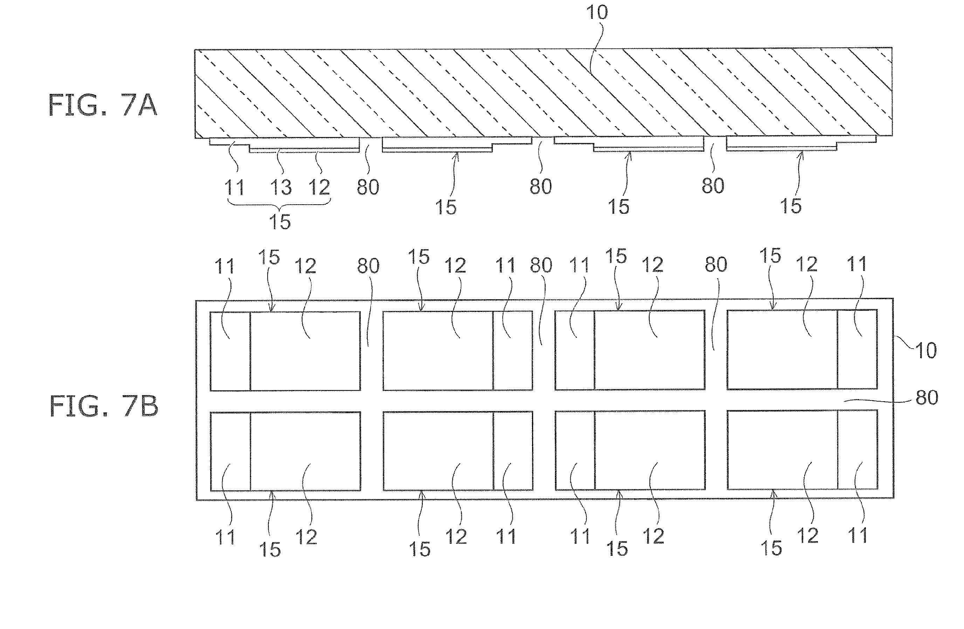

As shown in FIG. 7B, the first region is larger than the second region in the second face of the semiconductor layer 15. That is, the area of the second semiconductor layer 12 that includes the light emitting layer 13 is larger than the exposed area of the first semiconductor layer 11 that does not include the light emitting layer 13.

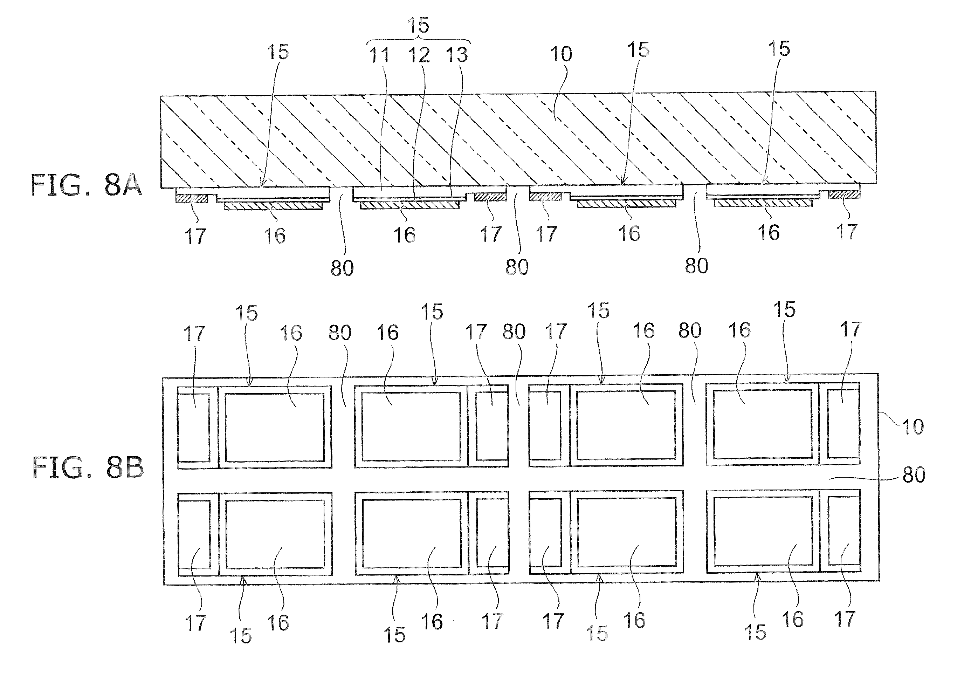

In addition, as shown in FIG. 8B, on the semiconductor layer 15, the area of the p-side electrode 16 that is provided on the first region that includes the light emitting layer 13 is larger than the area of the n-side electrode 17 that is provided on the second region that does not include the light emitting layer 13. Accordingly, a relatively wide light emitting area is obtained. Here, the layout of the p-side electrodes 16 and the n-side electrodes 17, which is shown in FIG. 8B, is an example, and the embodiment is not limited thereto.

A first insulating film (hereinafter, simply referred to as an insulating film 18) is provided on the second face side of the semiconductor layer 15. The insulating film 18 covers the semiconductor layer 15, the p-side electrode 16, and the n-side electrode 17. In addition, the insulating film 18 covers the side surfaces of the light emitting layer 13 and the second semiconductor layer 12 for the protection thereof.

In addition, another insulating film (for example, a silicon oxide film) may be provided between the insulating film 18 and the semiconductor layer 15. The insulating film 18, for example, is formed of a resin such as polyimide that is superior for the patterning of fine openings. Alternatively, an inorganic film such as a silicon oxide film or a silicon nitride film may be used as the material of the insulating film 18.

The insulating film 18 is not provided on the first face 15a. The insulating film 18 covers a side surface 15c for the protection, which extends from the first face 15a to the second face in the semiconductor layer 15.

A p-side interconnection layer 21 and an n-side interconnection layer 22 are provided on a face of the insulating film 18 opposite to the second face of the semiconductor layer 15, so as to be separated from each other.

Parts of the p-side interconnection layer 21 are provided in a plurality of first openings 18a that are formed in the insulating film 18 up to the p-side electrodes 16, and the p-side interconnection layer 21 is electrically connected to the p-side electrodes 16. A part of the n-side interconnection layer 22 is also provided in a second opening 18b that is formed in the insulating film 18 up to the n-side electrodes 17, and the n-side interconnection layer 22 is electrically connected to the n-side electrodes 17.

A p-side metal pillar 23 is provided on a face of the p-side interconnection layer 21 opposite to the p-side electrode 16. Then, a p-side interconnection according to the embodiment includes the p-side interconnection layer 21, the p-side metal pillar 23, and a metal film 19 that serves as a seed layer to be described later.

An n-side metal pillar 24 is provided on a face of the n-side interconnection layer 22 opposite to the n-side electrodes 17. Then, an n-side interconnection according to the embodiment includes the n-side interconnection layer 22, the n-side metal pillar 24, and the metal film 19 that is used as the seed layer.

A resin layer 25 serving as a second insulating film is stacked on the insulating film 18. The resin layer 25 covers the periphery of the p-side interconnection and the periphery of the n-side interconnection. In addition, the resin layer 25 is filled up between the p-side metal pillar 23 and the n-side metal pillar 24.

The side surfaces of the p-side metal pillar 23 and the n-side metal pillar 24 are covered with the resin layer 25. A face of the p-side metal pillar 23 opposite to the p-side interconnection layer 21 is exposed from the resin layer 25 and serves as a p-side external terminal 23a. A face of the n-side metal pillar 24 opposite to the n-side interconnection layer 22 is exposed from the resin layer 25 and serves as an n-side external terminal 24a.

The p-side external terminal 23a and the n-side external terminal 24a are bonded to a pad formed in a mounting substrate through a bonding member such as a solder, other metal, a material having conductivity, or the like.

The p-side external terminal 23a and the n-side external terminal 24a are exposed on the same face (the lower face in FIG. 1) of the resin layer 25, having a longer distance therebetween than a distance between the p-side interconnection layer 21 and the n-side interconnection layer 22 on the insulating film 18. The p-side external terminal 23a and the n-side external terminal 24a are separated from each other with such a distance, so that the external terminals do not form a short circuit via solder or the like at the time of being mounted on the mounting substrate.

On the other hand, the p-side interconnection layer 21 may approach the n-side interconnection layer 22 up to a process limit, and accordingly, the area of the p-side interconnection layer 21 may be widened. Thereby, the contact area can be enlarged between the p-side interconnection layer 21 and the p-side electrode 16.

Furthermore, the area of the p- side interconnection layer 21 that is in contact with the p- side electrodes 16 through the plurality of first openings 18a is possible to be larger than the area of the n- side interconnection layer 22 that is in contact with the n- side electrodes 17 through the second openings 18b.

As a result, the current distribution toward the light emitting layer 13 is improved, and the heat dissipation of the light emitting layer 13 can be improved.

In the n-side interconnection layer 22, the portion extending on the insulating film 18 can be formed to have larger area than the contact portion that is in contact with the n-side electrodes 17.

According to the embodiment, a high optical output can be acquired, since the light emitting layer 13 is formed over the first region that is larger than the second region on which the n-side electrode 17 is provided. In addition, the n-side interconnection layer 22 having a larger area than the n-side electrode 17 can be provided on the mounting face side.

The first semiconductor layer 11 is electrically connected to the n-side metal pillar 24 having the n-side external terminal 24a through the n-side electrode 17, the metal film 19, and the n-side interconnection layer 22. The second semiconductor layer 12 including the light emitting layer 13 is electrically connected to the p-side metal pillar 23 having the p-side external terminal 23a through the p-side electrode 16, the metal film 19, and the p-side interconnection layer 21.

The p-side metal pillar 23 is thicker than the p-side interconnection layer 21, and the n-side metal pillar 24 is thicker than the n-side interconnection layer 22. Each thickness of the p-side metal pillar 23, the n-side metal pillar 24, and the resin layer 25 is larger than that of the semiconductor layer 15. Here, the "thickness" represents a thickness in the vertical direction in FIG. 1.

In addition, each thickness of the p-side metal pillar 23 and the n-side metal pillar 24 is larger than that of a stacked body that includes the semiconductor layer 15, the p-side electrode 16, the n-side electrode 17, and the insulating film 18. In addition, the aspect ratio (the ratio of the thickness to the planar size) of each one of the metal pillars 23 and 24 is not limited to be one or more, and the ratio may be less than one. In other words, each thickness of the metal pillars 23 and 24 may be smaller than the planar size of the metal pillars 23 and 24.

According to the embodiment, even though a substrate 10 used for forming the semiconductor layer 15 is removed as described later, the mechanical strength of the semiconductor light emitting device 100 can be maintained, since the semiconductor layer 15 is stably supported by the p-side metal pillar 23, the n-side metal pillar 24, and the resin layer 25.

Copper, gold, nickel, silver, and the like can be used as the materials of the p- side interconnection layer 21, the n- side interconnection layer 22, the p- side metal pillar 23, and the n- side metal pillar 24. Among these materials, copper is superior to the other material in thermal conductivity, resistance for migration, and adhesiveness to an insulating material.

The resin layer 25 reinforces the p-side metal pillar 23 and the n-side metal pillar 24. It is preferable that the thermal expansion coefficient of the resin layer 25 is the same as or close to the thermal expansion coefficient of the mounting substrate. As examples of such a resin layer 25, there are an epoxy resin, a silicone resin, a fluorine resin, and the like.

In addition, when the semiconductor light emitting device 100 is mounted on the mounting substrate through the p-side external terminal 23a and the n-side external terminal 24a, the stress applied to the semiconductor layer 15 through soldering or the like can be absorbed and relieved by the p-side metal pillar 23 and the n-side metal pillar 24.

The p-side interconnection that includes the p-side interconnection layer 21 and the p-side metal pillar 23 is connected to the p-side electrode 16 through a plurality of vias 21a that are provided inside the plurality of first openings 18a and are separated from each other. Accordingly, an effective stress relieving can be obtained through the p-side interconnection.

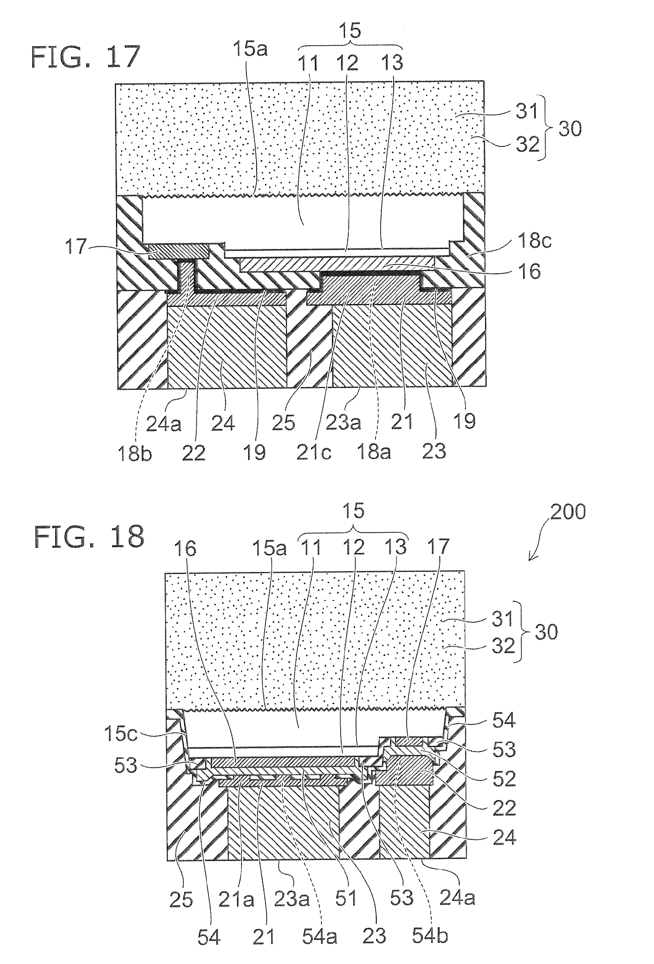

Alternatively, as shown in FIG. 17, the p- side interconnection layer 21 may be connected to the p- side electrode 16 through a post 21c that is provided inside one large first opening 18a and has a planar size larger than the via 21a. In such a case, the heat dissipation of the light emitting layer 13 can be improved through the p- side electrode 16, the p- side interconnection layer 21, and the p- side metal pillar 23, all of which are formed of metal.

As described later, the substrate 10 used for a crystal growth of the semiconductor layer 15 is removed from the first face 15a. Accordingly, the height of the semiconductor light emitting device 100 can be lowered.

A fine concavo-convex is formed on the first face 15a of the semiconductor layer 15 using wet etching (frost process), where an alkali-based solution is applied to the first face 15a. The light emitted from the light emitting layer 13 can be extracted outside through the first face 15a, suppressing light reflection at various incident angles by providing the concavo-convex on the first face 15a.

A fluorescent substance layer 30 is provided on the first face 15a. The fluorescent substance layer 30 includes a transparent resin 31 and a plurality of fluorescent substances 32, which have a particle or powder form, dispersed in the transparent resin 31.

The transparent resin 31 has transparency for the lights emitted from the light emitting layer 13 and the fluorescent substance 32. For example, a silicone resin, an acrylic resin, a phenyl resin, or the like may be used as the transparent resin 31.

The fluorescent substance 32 absorbs the light emitted from the light emitting layer 13 as excited light and emits wavelength-converted light. Accordingly, the semiconductor light emitting device 100 can emit mixed lights emitted from the light emitting layer 13 and the fluorescent substance 32.

For example, the light emitting layer 13 emits light having a peak wavelength of 480 nm or less, and the fluorescent substance 32 emits light having a peak wavelength of 480 nm or more. In a case where the fluorescent substance 32 is a yellow fluorescent substance that emits yellow light, a white color, a light bulb color, or the like can be obtained as a mixed color of blue light emitted from the light emitting layer 13, which contains a GaN-based material, and the yellow light emitted from the fluorescent substance 32. In addition, the fluorescent substance layer 30 may be configured to contain a plurality of types of fluorescent substances (for example, a red fluorescent substance that emits red light and a green fluorescent substance that emits green light).

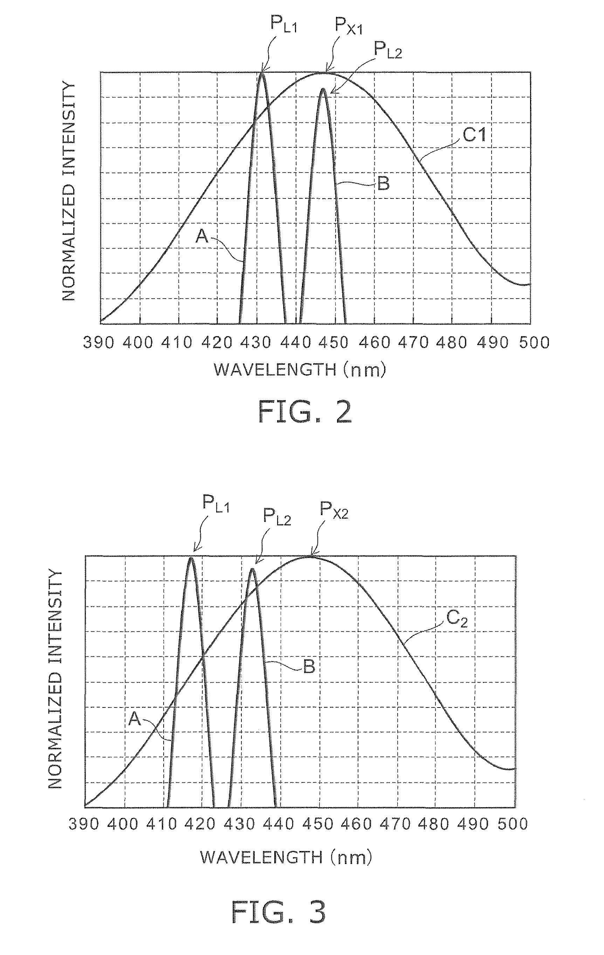

FIG. 2 is a graph that shows the characteristics of a fluorescent substance 32a according to the first embodiment. In the graph, the vertical axis represents normalized intensities of the radiation and excitation spectrums that are normalized with respective peak intensities, and the horizontal axis represents a light wavelength.

FIG. 2 shows excitation spectrum $C_1$ of the fluorescent substance 32a and radiation spectrums A and B of the light emitting layer 13. Here, the radiation spectrum A represents the light emitting characteristics at the room temperature, that is, at an operating environment temperature of 20°C, and radiation spectrum B represents the light emitting characteristics at an operating environment temperature of 140°C.

Here, the operating environment temperature refers to the temperature of the environment at which the semiconductor light emitting device 100 is operated and is different from the temperature of the light emitting layer 13. For example, the semiconductor light emitting device 100 is operated in accordance with a predetermined rated current, and the temperature of the light emitting layer 13 is higher than the operating environment temperature. In addition, the rated current is a driving current that is appropriate for operating the semiconductor light emitting device 100 and, for example, is set to a current range in which a predetermined life can be assured depending on the device structure and the size of the semiconductor layer 15.

As shown in FIG. 2, the radiation spectrum of the light emitting layer 13 under constant-current operation is shifted to a longer wavelength side in accordance with a rise in the operating environment temperature. For example, the peak wavelength of radiation spectrum A is 435 nm, and the peak wavelength of radiation spectrum B is 443 nm.

In addition, the intensity of the radiation spectrum of the light emitting layer 13 decreases in accordance with a rise in the operating environment temperature. For example, in a case where the peak intensity of radiation spectrum A is normalized to one, the peak intensity of radiation spectrum B is 0.96.

The fluorescent substance 32a is excited by the light emitted from the light emitting layer 13. As shown in FIG. 2, the peak $P_{X1}$ of the excitation spectrum $C_1$ of the fluorescent substance 32a, for example, is located at a light wavelength of 443 nm. On the other hand, the peak wavelength of radiation spectrum A is 435 nm. In other words, in the embodiment, the peak wavelength of the radiation spectrum of the light emitting layer 13 at the room temperature is shorter than the peak wavelength of the excitation spectrum of the fluorescent substance 32a. On the other hand, the peak wavelength of radiation spectrum B is 443 nm, and the peak wavelength of the radiation spectrum of the light emitting layer 13 at an operating environment temperature of 140°C coincides with the peak wavelength of the excitation spectrum of the fluorescent substance 32a.

Here, the coincidence of the peak wavelengths not only includes the coincidence in the strict sense but also includes rough coincidence. In other words, the peak wavelength of the radiation spectrum of the light emitting layer 13 may be located near the peak wavelength of the excitation spectrum of the fluorescent substance 32a.

As above, in the embodiment, the light emitting peak $P_{L1}$ of the light emitting layer 13 at the room temperature is on a shorter wavelength side than the excitation peak $P_{X1}$ of the fluorescent substance 32a and is shifted to the longer wavelength side in accordance with a rise in the operating environment temperature. In a case where the operating environment temperature is 140°C, the light emitting peak $P_{L1}$ of the light emitting layer 13 coincides with the excitation peak $P_{X1}$. In other words, the excitation intensity of the fluorescent substance increases in accordance with a rise in the operating environment temperature and has its maximum at 140°C. Accordingly, the light emitting intensity of the light emitting layer 13 that decreases in accordance with a rise in the operating environment temperature is compensated, whereby the temperature variation in the light output of the semiconductor light emitting device 100 can be suppressed.

For example, in a case where the maximum operating environment temperature of the semiconductor light emitting device 100 is 140°C, the temperature variation in the light output can be suppressed in a range from the room temperature to 140°C. In addition, a temperature at which the light emitting peak $P_{L1}$ of the light emitting layer 13 coincides with the excitation peak $P_{X1}$ is not limited to 140°C, and, for example, an arbitrary maximum operating environment temperature can be set by adjusting the composition of the fluorescent substance,

Here, the operating environment maximum temperature is a maximum temperature that can be considered under the environment in which the semiconductor light emitting device is used. The characteristics of the semiconductor light emitting device change in accordance with the operating temperature, and the reliability (life) of the device also changes. Accordingly, the operating environment maximum temperature can be set in correspondence with the characteristics and the reliability that are requested for the semiconductor light emitting device. In the embodiment, a fluorescent substance is selected and used to be suitable at the maximum operating temperature.

FIG. 3 is a graph that shows the characteristics of the fluorescent substance 32b according to a variation of the embodiment. The vertical axis is the normalized intensity that is normalized with respect to the peak intensity, and the horizontal axis is the light wavelength.

In the variation, in excitation spectrum $C_2$ of the fluorescent substance 32b, the excitation peak $P_{X2}$ is on a longer wavelength side than the light emitting peak $P_{L2}$ of the light emitting layer 13. The light emitting peak of the light emitting layer 13 is shifted in a direction in which the excitation intensity of the fluorescent substance 32b increases in accordance with a rise in the operating temperature of the semiconductor light emitting device 100. Although the excitation intensity of the fluorescent substance 32b increases in accordance with a shift of the light emitting peak, the change decreases, as the excitation intensity is closer to the excitation peak $P_{X2}$. Accordingly, by setting the shift range of the light emitting peak of the light emitting layer 13 to a shorter wavelength side than the excitation peak $P_{X2}$, it is possible to increase the excitation intensity of the fluorescent substance 32b in a more monotonous manner.

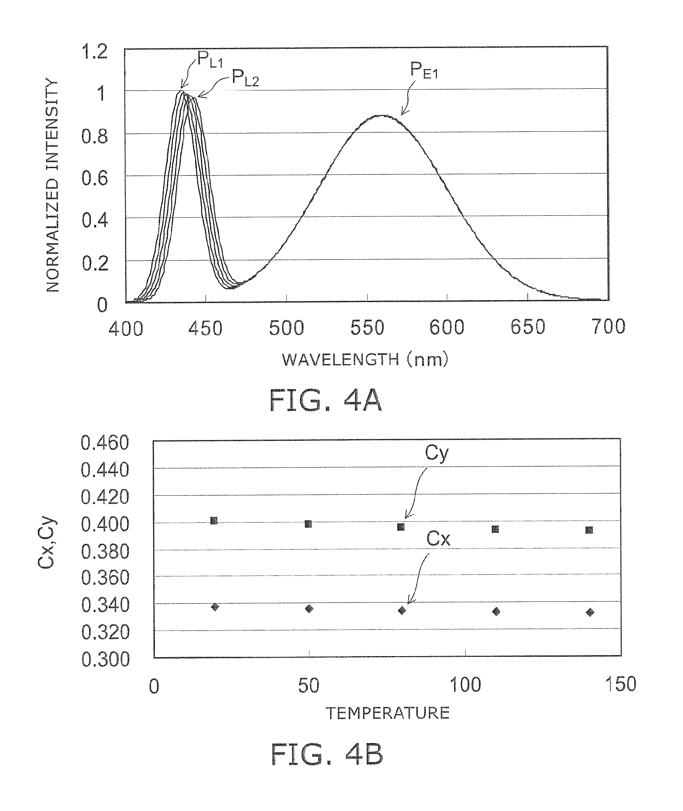

FIGS. 4A and 4B are graphs that represent the light emitting characteristics of the semiconductor light emitting device 100 that includes the fluorescent substance 32b according to the variation. FIG. 4A shows the radiation spectrum of output light, and FIG. 4B shows changes in the chromaticity coordinates Cx and Cy of the output light according to the temperature.

The radiation spectrum of the semiconductor light emitting device 100 shown in FIG. 4A includes peaks of blue light corresponding to the light emitting peaks $P_{L1}$ and $P_{L2}$ of the light emitting layer 13 and a peak of yellow light near 560 nm that is emitted from the fluorescent substance 32b.

By changing the operating environment temperature of the semiconductor light emitting device 100 from 20°C to 140°C, the peak of the blue light is shifted from the light emitting peak $P_{L1}$ to the light emitting peak $P_{L2}$, and the intensity of the light decreases. On the other hand, the excitation intensity of the fluorescent substance 32b, as shown in FIG. 3, increases in accordance with a wavelength shift of the blue light that is excitation light. As a result, the decrease in the intensity of the excitation light is compensated, whereby the variation in the peak intensity of the yellow light can be suppressed.

FIG. 4B shows changes in the chromaticity coordinates Cx and Cy between 20°C and 140°C. As shown in FIG. 4A, since the variation in the peak intensity of the yellow light is suppressed, changes in the chromaticity coordinates Cx and Cy according to the temperature is 0.01 or less.

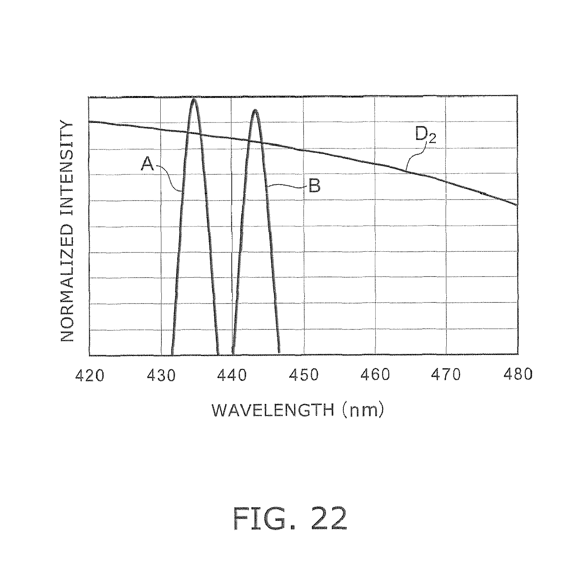

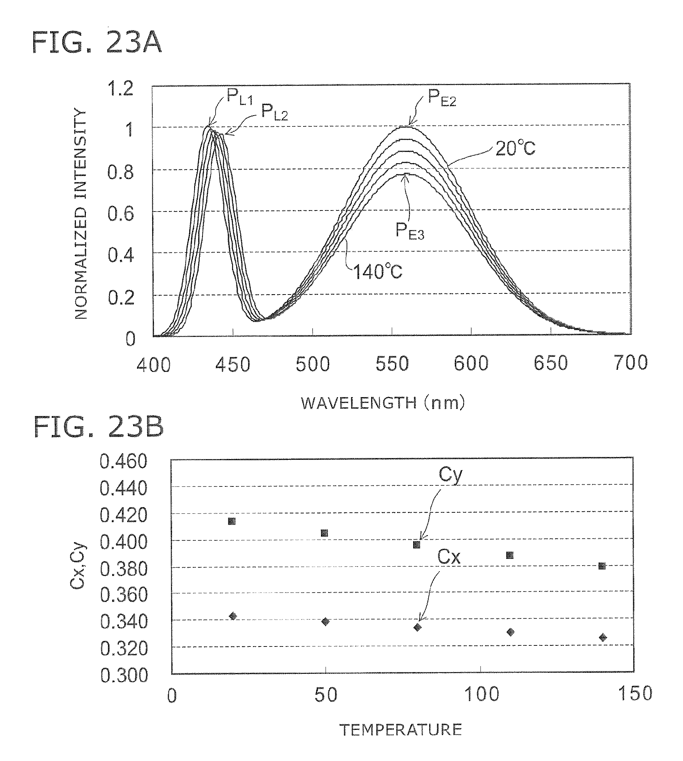

FIGS. 22, 23A, and 23B are graphs that show the characteristics of a semiconductor light emitting device 500 (not shown) according to a comparative example. The semiconductor light emitting device 500 according to the comparative example has the same configuration as that of the semiconductor light emitting device 100 shown in FIG. 1, and a fluorescent substance layer 30 includes a fluorescent substance 32f that is different from that of the semiconductor light emitting device 100.

FIG. 22 is a graph that represents excitation spectrum $D_2$ of the fluorescent substance 32f and light emitting spectrums A and B of the light emitting layer 13. Here, excitation spectrum $D_2$ of the fluorescent substance 32f has an excitation peak on a shorter wavelength side than the peaks $P_{L1}$ and $P_{L2}$ of light emitting spectrums A and B, and, as shown in FIG. 22, the excitation intensity decreases as the wavelength increases.

FIGS. 23A and 23B are graphs that represent the light emitting characteristics of the semiconductor light emitting device 500. FIG. 23A shows the radiation spectrum of output light, and FIG. 23B shows changes in the chromaticity coordinates Cx and Cy of the output light according to the temperature.

The radiation spectrum of the semiconductor light emitting device 500 shown in FIG. 23A includes peaks of blue light corresponding to the light emitting peaks $P_{L1}$ and $P_{L2}$ of the light emitting layer 13 and a peak of yellow light near 560 nm that is emitted from the fluorescent substance 32f.

By changing the operating environment temperature of the semiconductor light emitting device 500 from 20°C to 140°C, the peak of the blue light is shifted from light emitting peak $P_{L1}$ to light emitting peak $P_{L2}$. In accordance therewith, the excitation intensity of the fluorescent substance 32f decreases, and the peak intensity of the yellow light decreases from light emitting peak $P_{E1}$ to light emitting peak $P_{E3}$.

FIG. 23B shows changes of the chromaticity coordinates Cx and Cy between 20°C and 140°C. In accordance with a decrease in the peak intensity of the yellow light, the chromaticity coordinate Cx decreases from 0.34 to 0.32, and the chromaticity coordinate Cy decreases from 0.42 to 0.38. In other words, the semiconductor light emitting device 500 shows a change according to the temperature that is twice the change of the semiconductor light emitting device 100 shown in FIG. 4B according to the temperature or more.

As described above, in addition to the temperature variation in the light output according to the change in the operating environment temperature, the variation in the chromaticity can be suppressed in the semiconductor light emitting device 100 according to the embodiment. In the case of the fluorescent substance 32b, the peak wavelength of the radiation spectrum of the light emitting layer 13 is set on a shorter wavelength side than the peak wavelength of excitation spectrum $C_2$. Thus, although there is a case where the light output is lower than that of a case where the fluorescent substance 32a is used, a semiconductor light emitting device that suppresses the change in the light output according to the temperature and the variation in the chromaticity can be realized.

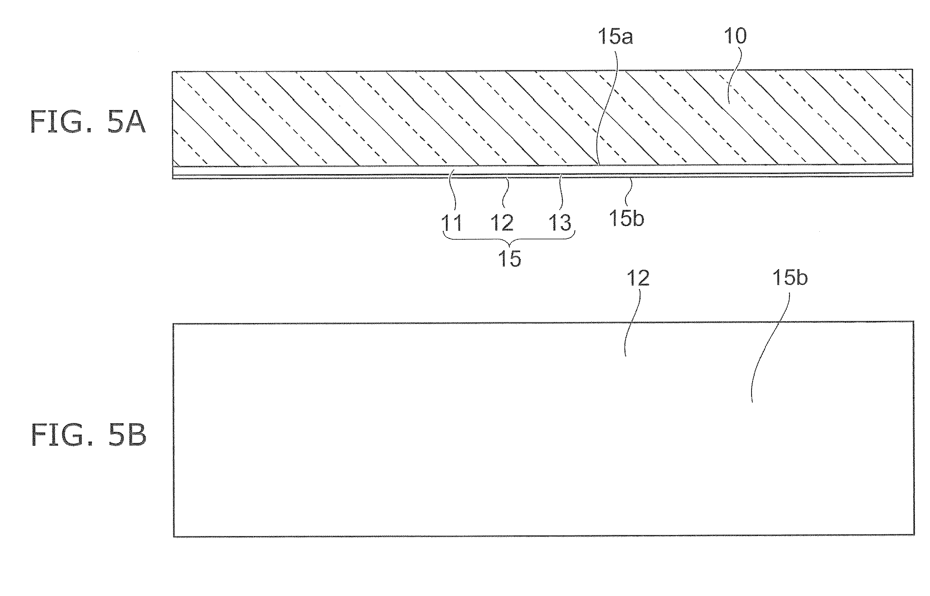

Next, a method of manufacturing the semiconductor light emitting device 100 according to the embodiment will be described with reference to FIGS. 5A to 16B. FIGS. 5A to 16B show partial areas of a wafer.

FIG. 5A is a schematic cross-sectional view of a stacked body in which a first semiconductor layer 11 and a second semiconductor layer 12 are formed on a major face (the lower face in FIG. 5A) of a substrate 10. FIG. 5B is a schematic view corresponding to a lower face in FIG. 5A.

The first semiconductor layer 11 is formed on the major face of the substrate 10, and the second semiconductor layer 12 including a light emitting layer 13 is formed thereon. For example, the first semiconductor layer 11 and the second semiconductor layer 12 may contain gallium nitride, and grown on a sapphire substrate by using a metal organic chemical vapor deposition (MOCVD) method. Alternatively, a silicon substrate may be used as the substrate 10.

A first face 15a of the semiconductor layer 15 is a face through which the first semiconductor layer 11 is in contact with the substrate 10, and a second face 15b of the semiconductor layer 15 is the surface of the second semiconductor layer 12 opposite to the first semiconductor layer 11.

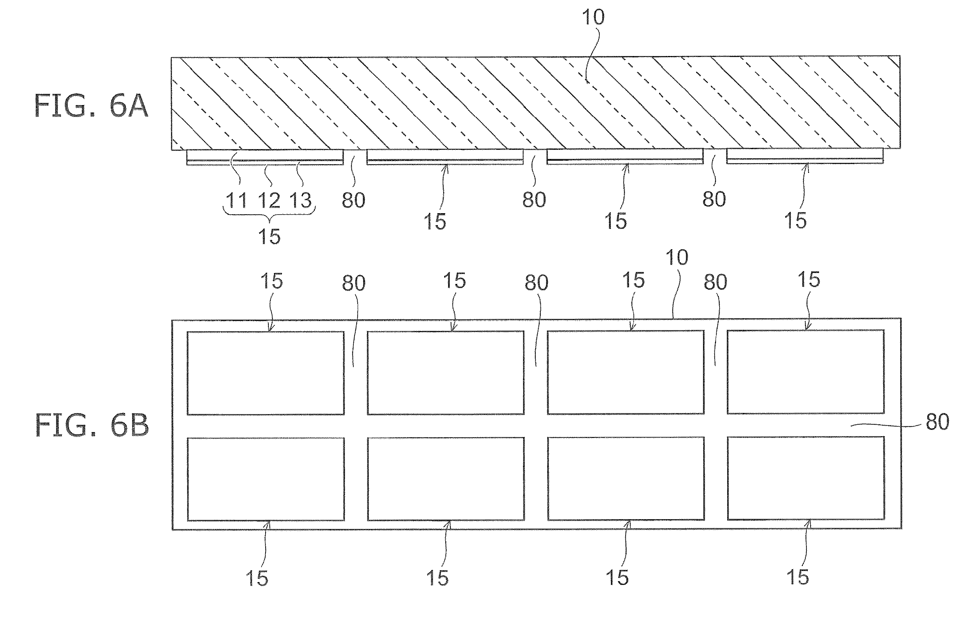

Next, as shown in FIG. 6A, a groove 80 is formed passing through the semiconductor layer 15 and reaching the substrate 10, for example, by using a reactive ion etching (RIE) method using a resist mask (not shown). As shown FIG. 6B corresponding to the lower face of FIG. 6A, the groove 80 is formed, for example, in a lattice pattern on the substrate 10, and separates the semiconductor layer 15 into a plurality of chips on the substrate 10.

Alternatively, the process for separating the semiconductor layer 15 into multiple parts may be performed after selectively removing the second semiconductor layer 12, or after forming the p- side electrode 16 and the n- side electrode.

Next, as shown in FIG. 7A and FIG. 7B corresponding to the lower face of FIG. 7A, parts of the second semiconductor layer 12 are removed so as to expose parts of the first semiconductor layer 11, for example, by using the RIE method using a resist mask (not shown). Each region in which the first semiconductor layer 11 is exposed does not include the light emitting layer 13.

Next, as shown in FIG. 8A and FIG. 8B corresponding to the lower face of FIG. 8A, p- side electrodes 16 and n- side electrodes 17 are formed on the second face of the semiconductor layer 15. The p- side electrodes 16 are formed on the surfaces of the second semiconductor layer 12. The n- side electrodes 17 are formed on the exposed surfaces of the first semiconductor layer 11.

The p-side electrodes 16 and the n-side electrodes 17, for example, are formed by using a sputtering method, a vapor deposition method, or the like. Either the p-side electrodes 16 or the n-side electrodes 17 may be formed first, or the p-side electrode 16 and n-side electrodes 17 may be simultaneously formed and inevitably made of the same material.

The p-side electrode 16 has preferably formed so as to reflect the light emitted from the light emitting layer 13. Hence, the p-side electrode 16 may include silver, silver alloy, aluminum, aluminum alloy, and the like. In addition, the p-side electrode 16 may include a metal protective film (barrier metal) formed on the reflection electrode, in order to prevent the reflection electrode from the sulfurization and the oxidization.

In addition, a silicon nitride film or a silicon oxide film may be formed as a passivation film by using a chemical vapor deposition (CVD) method between the p-side electrode 16 and the n-side electrode 17 or on the end face (side surface) of the light emitting layer 13. In addition, activated annealing may be performed as necessary for forming an ohmic contact between each electrode and the semiconductor layer.

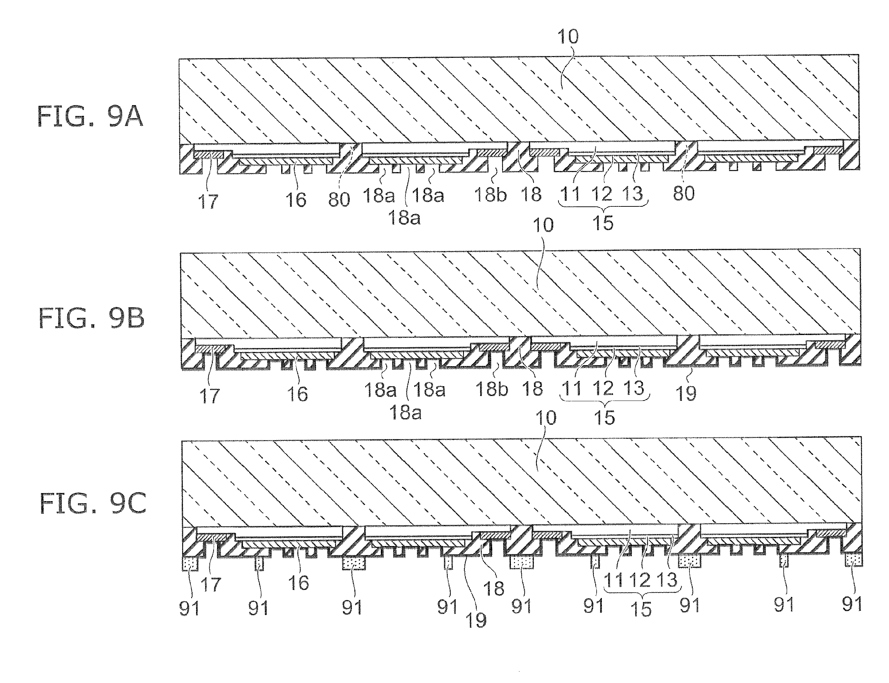

Next, after all the parts formed on the major face of the substrate 10 are covered with an insulating film 18 shown in FIG. 9A, and the insulating film 18 is patterned, for example, by using wet etching, whereby first openings 18a and a second opening 18b are selectively formed in the insulating film 18. A plurality of the first openings 18a are formed in the insulating film 18, and each of the first openings 18a reaches the p- side electrodes 16. The second opening 18b also reaches the n- side electrode 17.

For example, an organic material such as a photosensitive polyimide or benzocyclobutene can be used as the material of the insulating film 18. In such a case, the insulating film 18 can be directly exposed and developed using photo-lithography, and the first and second openings 18a, 18b are directly formed therein without using a resist mask.

Alternatively, an inorganic film such as a silicon nitride film or a silicon oxide film may be used as the insulating film 18. In a case where the insulating film 18 is an inorganic film, the first openings 18a and the second opening 18b are formed by selective etching using a resist mask formed on the insulating film 18.

Next, as shown in FIG. 9B, a metal film 19 is formed on the surface of the insulating film 18, the inner walls (the side wall and the bottom portion) of the first opening 18a, and the inner wall (the side wall and the bottom portion) of the second opening 18b. The metal film 19 is used as a seed metal for plating, which will be described later.

The metal film 19, for example, is formed by using a sputtering method. The metal film 19 includes a stacked film, for example, in which a titanium (Ti) layer and a copper (Cu) layer are stacked in order from the insulating film 18 side. Alternatively, an aluminum layer may be used instead of the titanium layer.

Next, as shown in FIG. 9C, resists 91 are selectively formed on the metal film 19, and Cu electroplating is performed using the metal film 19 as a current path.

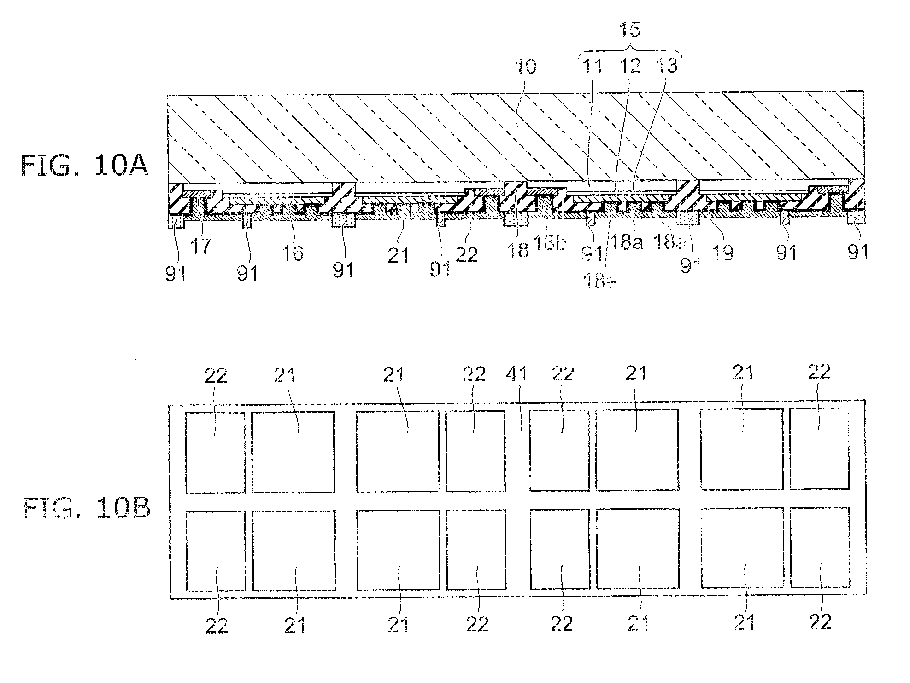

Accordingly, as shown in FIG. 10A and FIG. 10B corresponding to the lower face of FIG. 10A, a p- side interconnection layer 21 and an n- side interconnection layer 22 are selectively formed on the metal film 19. The p- side interconnection layer 21 and the n- side interconnection layer 22 are simultaneously formed, for example, by using copper plating.

The p-side interconnection layer 21 is also formed inside the first openings 18a and is electrically connected to the p-side electrode 16 via the metal film 19. In addition, the n-side interconnection layer 22 is formed also inside the second openings 18b and is electrically connected to the n-side electrodes 17 via the metal film 19.

The resists 91 that are used for plating the p-side interconnection layer 21 and the n-side interconnection layer 22 are removed by using solvent or oxygen plasma.

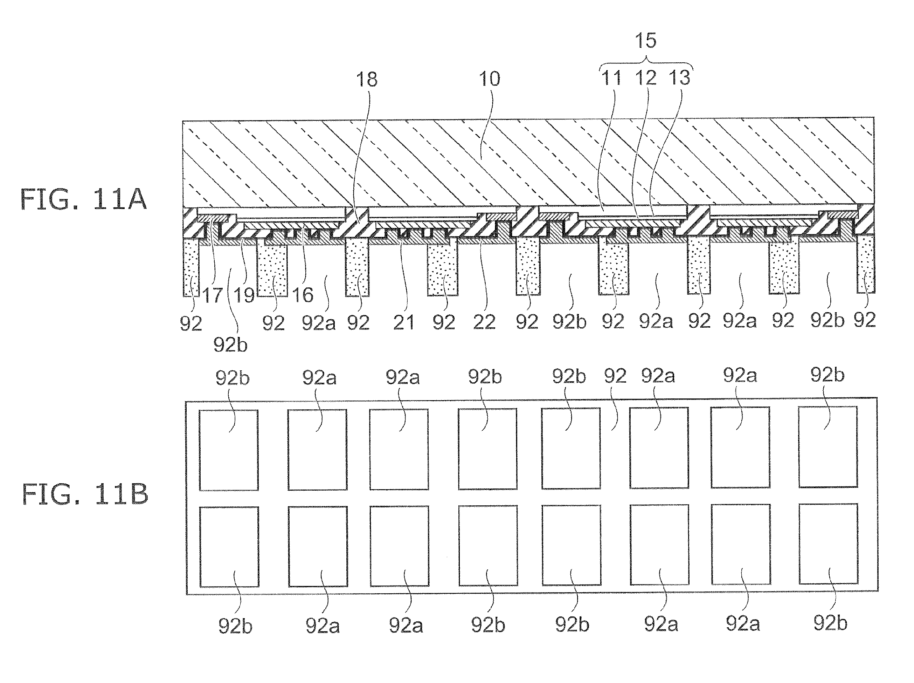

Next, as shown in FIG. 11A and FIG. 11B corresponding to the lower face of FIG. 11A, resists 92 are formed for forming metal pillars. The resist 92 is thicker than the above- described resist 91. It may be possible to leave the resists 91 without removing in the previous process, and the resists 92 are formed so as to overlap the resists 91. First openings 92a and second openings 92b are formed in the resists 92.

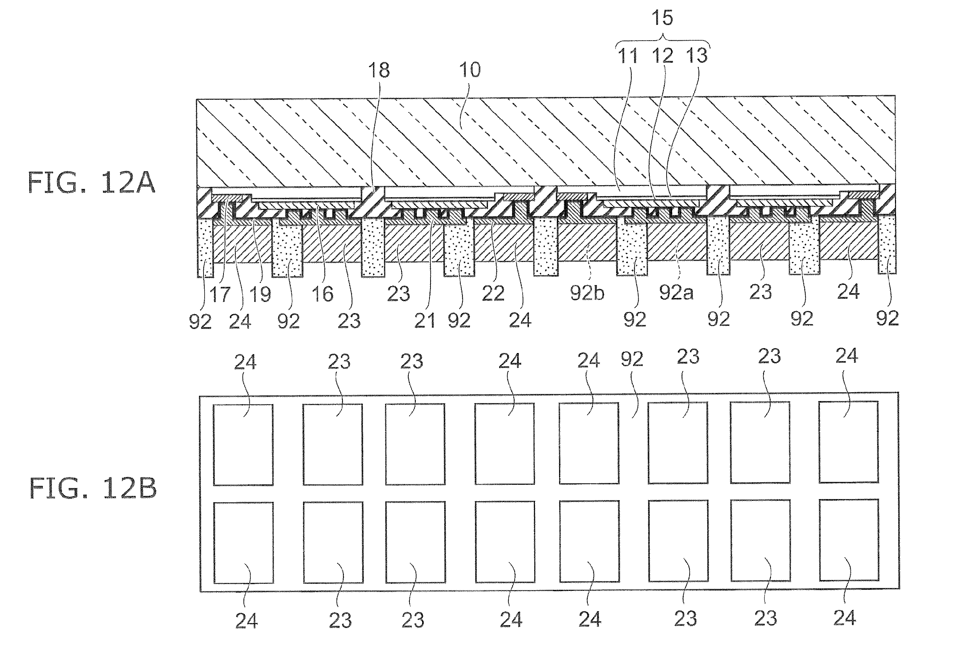

Then, Cu electroplating is performed using the metal film 19 as a current path and the resists 92 as a mask. Accordingly, as shown in FIG. 12A and FIG. 12B corresponding to the lower face of FIG. 12A, a p- side metal pillar 23 and an n- side metal pillar 24 are formed on the p- side interconnection layer 21 and n- side interconnection layer 22 respectively.

The p-side metal pillar 23 is formed on the p-side interconnection layer 21 inside the first opening 92a that is formed in the resist 92. The n-side metal pillar 24 is formed on the n-side interconnection layer 22 inside the second opening 92b that is formed in the resist 92. The p-side metal pillar 23 and the n-side metal pillar 24 are simultaneously formed by using copper plating, for example.

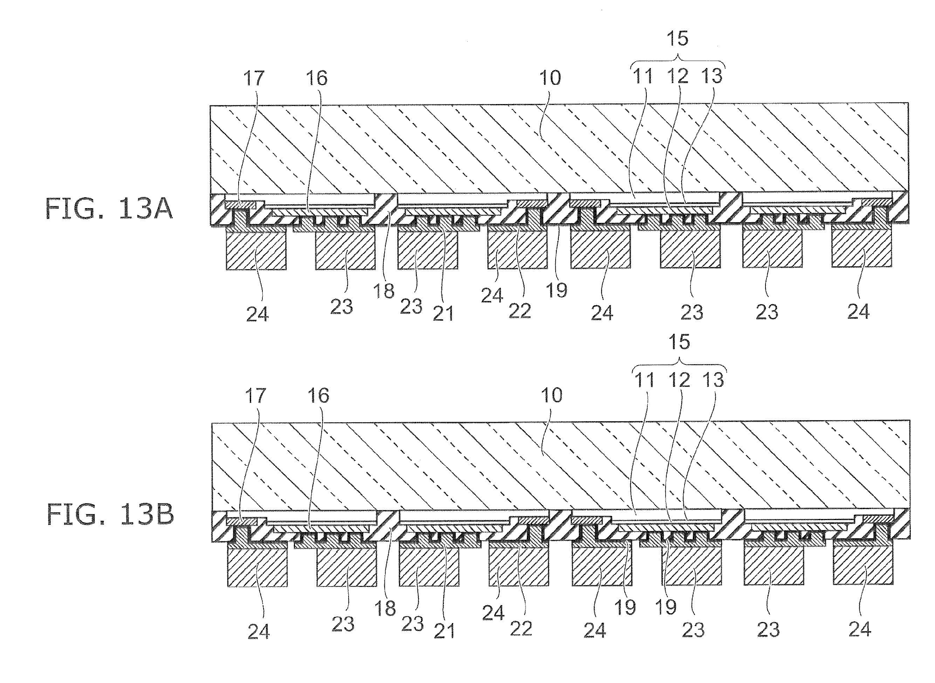

The resist 92, as shown in FIG. 13A is removed, for example, by using solvent or oxygen plasma. Thereafter, exposed parts of the metal film 19 are removed by wet etching while using the p-side metal pillar 23, the n-side metal pillar 24, the p-side interconnection layer 21, and the n-side interconnection layer 22 as a mask. Accordingly, as shown in FIG. 13B, the p-side interconnection layer 21 and the n-side interconnection layer 22 is separated from each other on the insulating film 18, cutting off the electric connection therebetween.

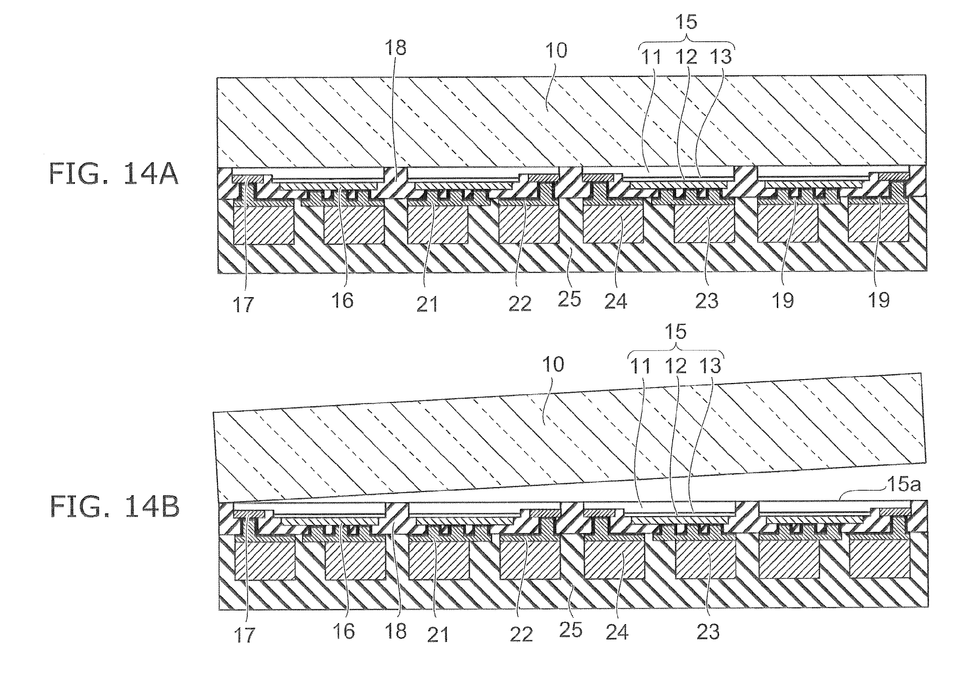

Next, as shown in FIG. 14A, a resin layer 25 is stacked on the insulating film 18. The resin layer 25 covers the p- side interconnection layer 21, the n- side interconnection layer 22, the p- side metal pillar 23, and the n- side metal pillar 24.

The resin layer 25 has an insulating property. In addition, for example, carbon black may be dispersed in the resin layer 25 so as to shield the light emitted from the light emitting layer 13.

Next, the substrate 10 is removed as shown in FIG. 14B. In a case where the substrate 10 is a sapphire substrate, the substrate 10 can be removed, for example, by using a laser lift- off method. More specifically, laser light is emitted from the backside of the substrate 10 toward the first semiconductor layer 11. The laser light has transparency for the substrate 10 and has a wavelength in an absorption band of the first semiconductor layer 11.

When the laser light arrives at an interface between the substrate 10 and the first semiconductor layer 11, part of the first semiconductor layer 11 that is located near the interface absorbs energy of the laser light and decomposes. The first semiconductor layer 11 is decomposed into gallium (Ga) and nitrogen gas. According to the decomposition reaction, a minute gap is formed between the substrate 10 and the first semiconductor layer 11, whereby the substrate 10 and the first semiconductor layer 11 are separated from each other.

The laser light is radiated over the whole wafer, scanning a plurality of areas thereof and a plurality of times for each area, whereby the substrate 10 is removed from the first semiconductor layer 11.

In a case where the substrate 10 is a silicon substrate, the substrate 10 can be removed by etching from the first semiconductor layer 11.

The above-described stacked body formed on the major face of the substrate 10 is reinforced by the p-side metal pillar 23 thicker than the semiconductor layer 15, the n-side metal pillar 24, and the resin layer 25, and accordingly, the wafer shape can be maintained even after the substrate 10 is removed therefrom.

In addition, the resin layer 25 and the metal that configures the p-side metal pillar 23 and the n-side metal pillar 24 are more flexible than the material of the semiconductor layer 15. That is, the semiconductor layer 15 is supported by the flexible support members. Accordingly, when strong internal stress contained in the wafer during the epitaxial growth of the semiconductor layer 15 is released at once by removing the substrate 10, the released stress may be absorbed by the resin layer 25, the p-side metal pillar 23 and the n-side metal pillar 24, preventing the semiconductor layer 15 from being destroyed.

The first face 15a of the semiconductor layer 15 is cleaned after removing the substrate 10 therefrom. For example, gallium (Ga) that is stuck to the first face 15a is removed by using rare hydrofluoric acid or the like.

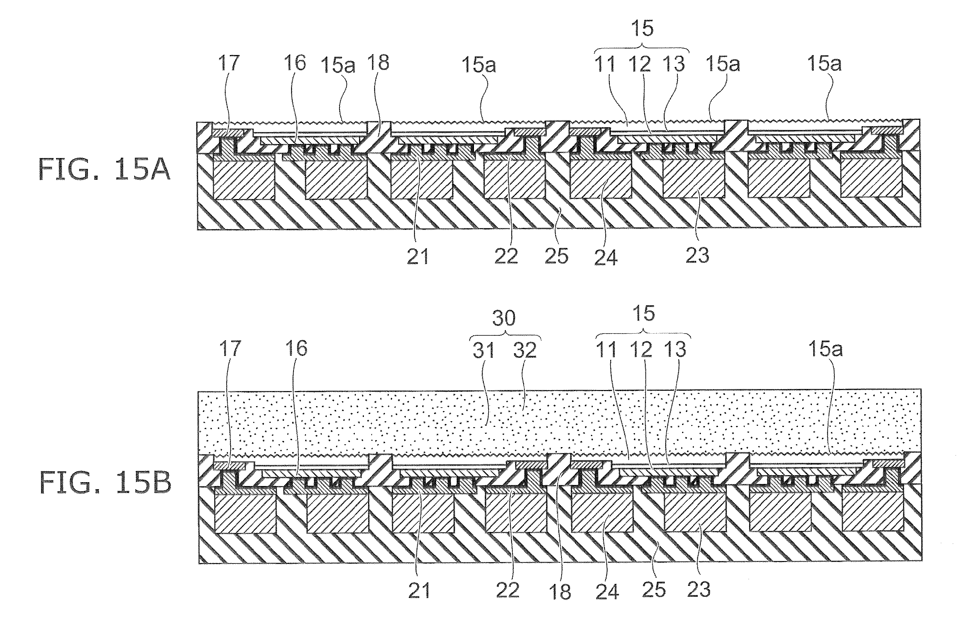

Thereafter, wet etching is performed for the first face 15a, for example, by using a potassium hydroxide (KOH) solution, tetramethylammonium hydroxide (TMAH), or the like. Accordingly, the concavo- convex is formed on the first face 15a due to a difference in the etching speed that depends on the direction of the crystal plane, as shown in FIG. 15A. Alternatively, the concavo- convex may be formed on the first face 15a by etching using a resist mask. The concavo-convex formed on the first face 15a may improve the light extraction efficiency.

Next, as shown in FIG. 15B, a fluorescent substance layer 30 is formed on the first face 15a. The fluorescent substance layer 30 is also formed on the insulating film 18 between semiconductor layers 15 adjacent to each other.

The fluorescent substance 32 dispersed into the fluorescent substance layer 30 may include, for example, a yellow fluorescent substance or a red fluorescent substance, and a green fluorescent substance.

As examples of a fluorescent substance that emits yellow fluorescence, there are materials represented by the following chemical formulas.

$Li (Eu, Sm) W_2O_8$,

$(Y, Gd)_3 (Al, Ga)_5O_{12}$,

$Li_2SrSiO_4 : Eu^{2+}$,

$(Sr (Ca, Ba)_3SiO_5 : Eu^{2+}$

$SrSi_2ON_{2.7} : Eu^{2+}$

As examples of a fluorescent substance that emits red fluorescence, there are materials represented by the following chemical formulas.

$La_2O_2S : Eu, Sm$,

$LaSi_3N_5 : Eu^{2+}$

$\alpha$- sialon : $Eu^{2+}$,

$CaAlSiN_3 : Eu^{2+}$,

$(SrCa) AlSiN_3 : Eu^{X+}$,

$Sr_x (SiyAl_3)_z (O_xN) : Eu^{X+}$

As examples of a fluorescent substance that emits green fluorescence, there are materials represented by the following chemical formulas.

$Al_5Lu_3O_{12} : Ce$,

$(Ba, Sr, Mg) O \cdot aAl_2O_3 : Mn$,

$(BaSr) SiO_4 : Eu$,

$\alpha$- sialon : $Yb^{2+}$

$\beta$- sialon : $Eu^{2+}$

$(CaSr) Si_2O_4N_7 : Eu^{2+}$,

$Sr (SiAl) (ON) : Ce$

The above fluorescent substances are not described for the purpose of limitation, and these materials may be substituted with other materials.

For example, when the wavelength of the light emitting peak of the light emitting layer 13 in the room temperature operating environment is in the range of 430 to 480 nm, the fluorescent substance 32 dispersed in the fluorescent substance layer 30 may be selected from the above-described fluorescent substances. In other words, the fluorescent substance 32 is selected on the basis of the dependency of the light emitting peak of the light emitting layer 13 on the temperature, so that the wavelength of the light emitting peak at the maximum operating temperature 140°C coincides with the wavelength of the excitation peak. Alternatively, a fluorescent substance may be selected, whereby the wavelength of the light emitting peak of the light emitting layer 13 at the maximum operating temperature 140°C is shorter than the excitation peak of the fluorescent substance 32.

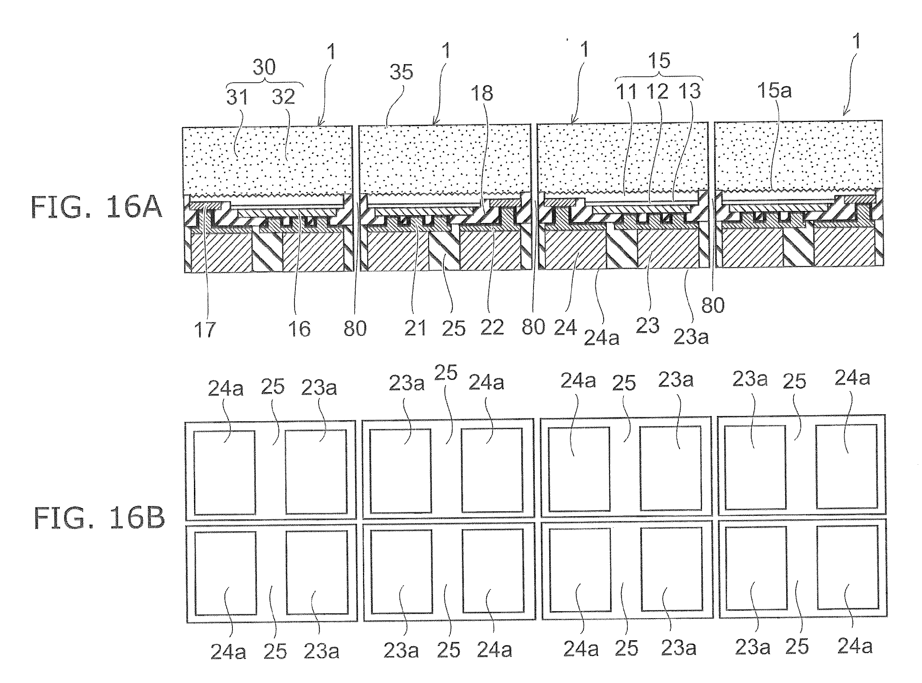

The transparent resin 31 is thermally cured after a transparent resin 31 of a liquid phase in which fluorescent substances 32 are dispersed is supplied to the upper side of the first face 15a, for example, by using a method such as a printing method, a potting method, a molding method, or a compression molding. Next, the surface (the lower face in FIG. 15B) of the resin layer 25 is ground such that, as shown in FIG. 16A and FIG. 16B corresponding to the lower face of FIG. 16A, the p-side external terminals 23a and the n-side external terminals 24a are exposed.

Thereafter, at the position of the above- described groove 80, the transparent film 35, the wafer is diced through the fluorescent substance layer 30, the insulating film 18, and the resin layer 25 so as to separate into a plurality of semiconductor light emitting devices 100. For example, the dicing is performed using a dicing blade. Alternatively, the dicing may be performed using laser radiation.

When the dicing is performed, the substrate 10 has been already removed. In addition, since the semiconductor layer 15 is also removed in the groove 80, the semiconductor layer 15 can be prevented from damage, while the dicing is performed. In addition, the end portion (side surface) of the semiconductor layer 15 is covered with the insulating film 18. Thereby, the protection of the end portion can be obtained without any additional process after dicing into the plurality of semiconductor light emitting devices 100.

In addition, the semiconductor light emitting device 100 may have a single chip structure that includes one semiconductor layer 15 or a multiple-chip structure that includes a plurality of semiconductor layers 15.

Since each diced device includes a package protecting the semiconductor 15 and the interconnection formed therein, and the above-described manufacturing process before dicing are performed in the wafer state, it is possible to significantly reduce the production cost. In other words, the interconnection and the packaging are completed at the diced state. Accordingly, the productivity can be improved, and, as a result, the lowered price can be achieved in an easy manner.

FIG. 18 is a schematic cross-sectional view illustrating a semiconductor light emitting device 200 according to a variation of the first embodiment.

In the semiconductor light emitting device 200, a p-side pad 51 is provided on the p-side electrode 16, covering the surface and the side surface of the p-side electrode. The p-side electrode 16, for example, contains at least one of nickel (Ni), gold (Au), and rhodium (Rh), which can form an alloy together with gallium (Ga) contained in the semiconductor layer 15. The p-side pad 51 has higher reflectance than the p-side electrode 16 for the light emitted from the light emitting layer 13 and, for example, contains silver (Ag) as its main ingredient. In addition, the p-side pad 51 protects the p-side electrode 16 from oxidation or corrosion.

In addition, an n-side pad 52 is provided on the n-side electrode, covering the surface and the side surface of the n-side electrode 17. The n-side electrode 17, for example, contains at least one of nickel (Ni), gold (Au), and rhodium (Rh), which can form an alloy together with gallium (Ga) contained in the semiconductor layer 15. The n-side pad 52 has higher reflectance than the n-side electrode 17 for the light emitted from the light emitting layer 13 and, for example, contains silver (Ag) as its main ingredient. In addition, the n-side pad 52 protects the n-side electrode 17 from oxidation or corrosion.

On the second face of the semiconductor layer 15, an insulating film 53 formed, for example, from a silicone oxide film, a silicon nitride film, or the like is provided on the periphery of the p-side electrode 16 and the periphery of the n-side electrode 17. The insulating film 53 is also provided between the p-side electrode 16 and the n-side electrode 17 and between the p-side pad 51 and the n-side pad 52.

An insulating film 54 such as a silicone oxide film, a silicon nitride film, or the like is provided on the insulating film 53, the p-side pad 51, and the n-side pad 52. In addition, the insulating film 54 is provided also on the side surface 15c of the semiconductor layer 15 and covers the side surface 15c.

A p-side interconnection layer 21 and an n-side interconnection layer 22 are provided on the insulating film 54,. The p-side interconnection layer 21 is connected to the p-side pad 51 through the first opening 54a formed in the insulating film 54. The n-side interconnection layer 22 is connected to the n-side pad 52 through the second opening 54b formed in the insulating film 54.

The p-side interconnection layer 21 may be connected to the p-side pad 51 through a plurality of vias 21a, as shown in FIG.18, or may be connected to the p-side pad 51 through one post that has larger planar size than the via 21a.

The p-side metal pillar 23 that is thicker than the p-side interconnection layer 21 is provided on the p-side interconnection layer 21. The n-side metal pillar 24 that is thicker than the n-side interconnection layer 22 is provided on the n-side interconnection layer 22.

The resin layer 25 is stacked on the insulating film 54. The resin layer 25 covers the p-side interconnection that includes the p-side interconnection layer 21 and the p-side metal pillar 23, and the n-side interconnection that includes the n-side interconnection layer 22 and the n-side metal pillar 24. However, a face (a lower face in FIG.18) of the p-side metal pillar 23, which is disposed on a side opposite to the p-side interconnection layer 21, is exposed from the resin layer 25 so as to serve as the p-side external terminal 23a. Similarly, a face (a lower face in the diagram) of the n-side metal pillar 24, which is disposed on a side opposite to the n-side interconnection layer 22, is exposed from the resin layer 25 so as to serve as the n-side external terminal 24a.

Alternatively, it may be possible to make a semiconductor light emitting device of the side view type as described later, exposing the side surface of the p- side metal pillar 23 and the side surface of the n- side metal pillar 24.

The resin layer 25 is filled via the insulating film 54 inside the above-described groove 80 that separates the semiconductor layer 15 into multiple parts on the substrate 10. Accordingly, the side surface 15c of the semiconductor layer 15 is covered with the insulating film 54 that is an inorganic film and the resin layer 25 for protection.

Furthermore, the fluorescent substance layer 30 is provided on the first face 15a. The fluorescent substance layer 30 includes the transparent resin 31 and the fluorescent substance 32 dispersed therein. The fluorescent substance 32 is the above- described fluorescent substance 32a or 32b and suppresses the change depending on the temperature in the light output and the chromaticity of the semiconductor light emitting device 200.

Alternatively, the p- side interconnection layer 21 and the n- side interconnection layer 22 may be directly bonded to the pads of the mounting substrate without providing the p- side metal pillar 23 and the n- side metal pillar 24.

Furthermore, the p- side interconnection layer 21 and the p- side metal pillar 23 are not limited to be the separately formed ones, and the p- side interconnection may be provided with the p- side interconnection layer 21 and the p- side metal pillar 23, which are formed into a single body in the same process. Similarly, the n- side interconnection layer 22 and the n- side metal pillar 24 are not limited to be the separately formed ones, and the n- side interconnection may be provided with the n- side interconnection layer 22 and the n- side metal pillar 24, which is formed into a single body in the same process.

Second Embodiment

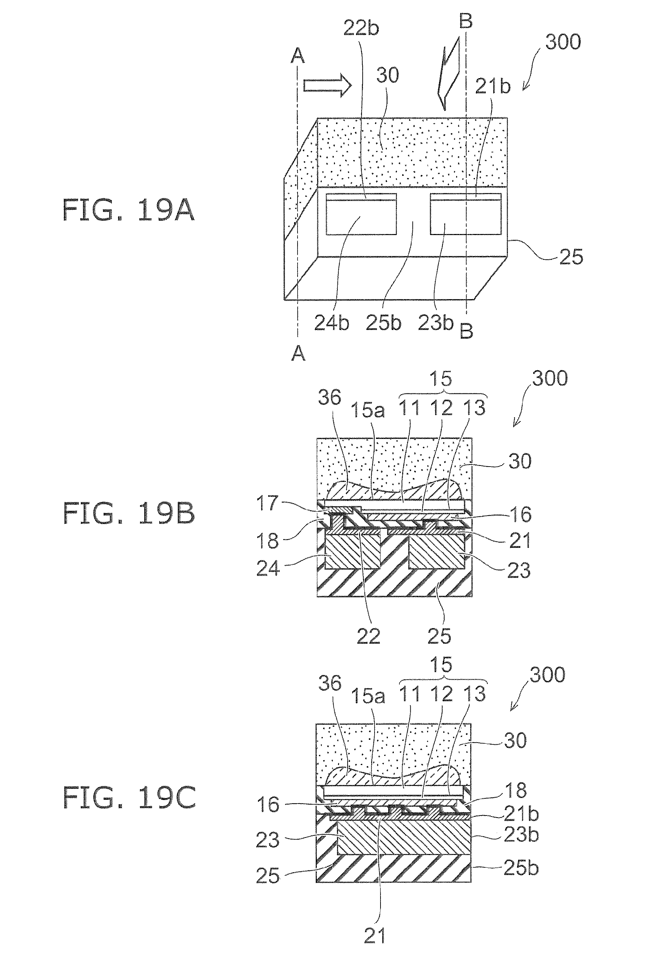

FIG. 19A is a schematic perspective view of a semiconductor light emitting device 2 according to a second embodiment. FIG. 19B is a cross-sectional view taken along line A - A shown in FIG. 19A. FIG. 19C is a cross-sectional view taken along line B - B shown in FIG. 19A.

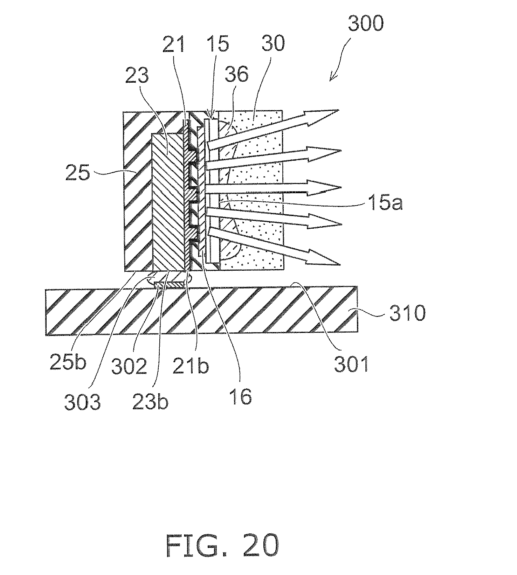

FIG. 20 is a schematic cross-sectional view of a light emitting module that has a configuration in which the semiconductor light emitting device 300 is mounted on a mounting substrate 310.

As shown in FIGS. 19A and 19C, a part of the side surface of the p-side metal pillar 23 is exposed from the resin layer 25 on a third face 25b that has a plane direction different from the first face 15a and the second face of the semiconductor layer 15. The exposed face serves as a p-side external terminal 23b for mounting the semiconductor light emitting device on an external mounting substrate.

The third face 25b is a face that is approximately perpendicular to the first face 15a and the second face of the semiconductor layer 15. The resin layer 25, for example, has four side surfaces of a rectangular shape, and one of the four side surfaces is the third face 25b.

A part of the side surface of the n-side metal pillar 24 is exposed from the resin layer 25 on the third face 25b. The exposed face serves as an n-side external terminal 24b for mounting the semiconductor light emitting device on the external mounting substrate.

In addition, as shown in FIG. 19A, a part of the side surface 21b of the p-side interconnection layer 21 is also exposed from the resin layer 25 on the third face 25b and serves as a p-side external terminal. Similarly, a part of the side surface 22b of the n-side interconnection layer 22 is also exposed from the resin layer 25 on the third face 25b and serves as an n-side external terminal.

Parts of the p-side metal pillar 23 other than the p-side external terminal 23b that is exposed on the third face 25b is covered with the resin layer 25. In addition, parts of the n-side metal pillar 24 other than the n-side external terminal 24b that is exposed on the third face 25b is covered with the resin layer 25.

In addition, parts of the p-side interconnection layer 21 other than the side surface 21b that is exposed on the third face 25b is covered with the resin layer 25. In addition, parts of the n-side interconnection layer 22 other than the side surface 22b that is exposed on the third face 25b is covered with the resin layer 25.

A lens 36 is provided between the first face 15a and the fluorescent substance layer 30. The lens 36 focuses the light emitted from the light emitting layer 13 and improves the light distribution. It may be also possible not to provide the lens 36.

The semiconductor light emitting device 300, as shown in FIG. 20, is mounted in a posture in which the third face 25b faces the mounting face 301 of the mounting substrate 310. The p-side external terminal 23b and the n-side external terminal 24b that are exposed on the third face 25b are bonded to the pad 302 that is formed on the mounting face 301 through soldering 303. In addition, an interconnection pattern is formed on the mounting face 301 of the mounting substrate 310, and the pad 302 is connected to the interconnection pattern.

The third face 25b is approximately perpendicular to the first face 15a that is the major light emitting face. Accordingly, in the posture in which the third face 25b is disposed toward the lower side, i.e. facing the mounting face 301 side, the first face 15a faces in the horizontal direction, not the upper side of the mounting face 301. That is, the semiconductor light emitting device 300 is a so-called side view type device in which light is emitted in the horizontal direction in a case where the mounting face 301 is set as the horizontal plane.

In the semiconductor light emitting device 300 of the side view type, the change in the light output and the chromaticity depending on the temperature can also be suppressed by using the fluorescent layer 30 that contains the fluorescent substances 32a and 32b,.

Third Embodiment

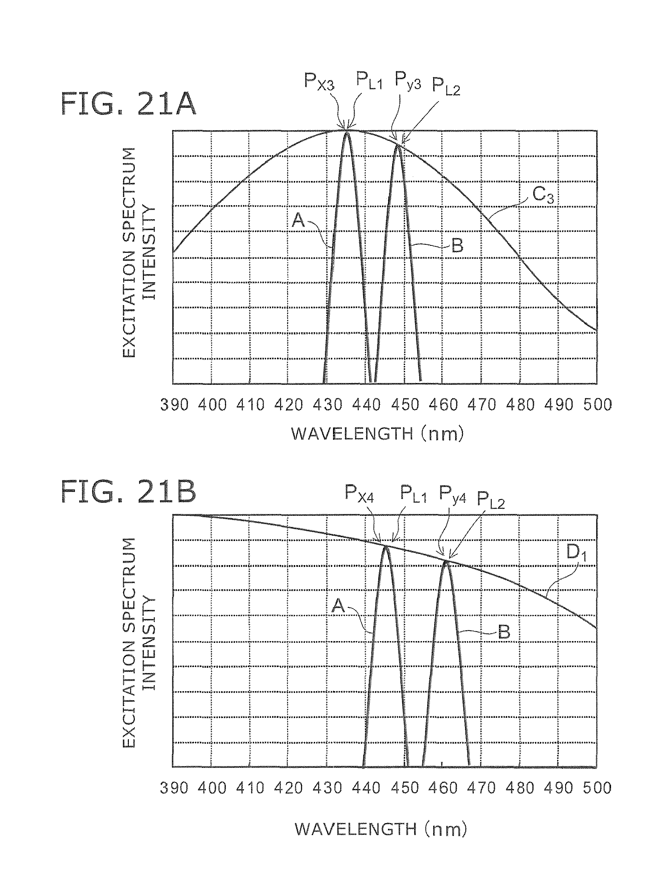

FIGS. 21A and 21B are graphs that represent the characteristics of a semiconductor light emitting device 400 (not shown) according to a third embodiment. The semiconductor light emitting device 400 has the same structure as the semiconductor light emitting device 100 shown in FIG. 1, and the fluorescent substance layer 30 contains fluorescent substances 32c and 32d that are different from the fluorescent substance in the semiconductor light emitting device 100.

In the example shown in FIG. 21A, the semiconductor light emitting device 400 contains the fluorescent substance 32c in the fluorescent substance layer 30. The peak wavelength of the radiation spectrum A of the light emitted from the light emitting layer 13 at the room temperature coincides with the peak wavelength of the excitation spectrum $C_3$ of the fluorescent substance 32c. In addition, a ratio $P_{L1}/P_{L2}$ of the peak intensity $P_{L1}$ to the peak intensity $P_{L2}$ is the same as a ratio $P_{X3}/P_{Y3}$ of the peak intensity $P_{X3}$ to the intensity $P_{Y3}$, where $P_{L1}$ is the peak intensity in the radiation spectrum of the light emitting layer 13 in the room temperature operation; $P_{L2}$ is the peak intensity in the radiation spectrum of the light emitting layer 13 at the maximum operating environment temperature; $P_{X3}$ is the peak intensity in the excitation spectrum $C_3$ of the fluorescent substance 32c; and $P_{Y3}$ is the intensity in the excitation spectrum of the fluorescent substance 32c corresponding to the peak wavelength of the radiation spectrum of the light emitting layer 13 at the maximum operating environment temperature. Here, the ratios are not only the same in a strict sense, but also are allowed to be approximately the same.

In the example shown in FIG. 21B, the semiconductor light emitting device 400 contains the fluorescent substance 32d in the fluorescent substance layer 30. The peak wavelength of the radiation spectrum A of the light emitted from the light emitting layer 13 in the room temperature operation is longer than the peak wavelength of the excitation spectrum $D_1$ of the fluorescent substance 32d. In addition, a ratio $P_{L1}/P_{L2}$ of the peak intensity $P_{L1}$ to the peak intensity $P_{L2}$ is the same as a ratio $P_{X4}/P_{Y4}$ of the intensity $P_{X4}$ to the intensity $P_{Y4}$, where $P_{L1}$ is the peak intensity in the radiation spectrum of the light emitting layer 13 in the room temperature operation; $P_{L2}$ is the peak intensity in the radiation spectrum of the light emitting layer 13 at the maximum operating environment temperature; $P_{X4}$ is the intensity in the excitation spectrum $D_1$ of the fluorescent substance 32d corresponding to the peak wavelength of the radiation spectrum of the light emitting layer 13 in a room-temperature operation; and $P_{Y4}$ is the intensity in the excitation spectrum of the fluorescent substance 32c corresponding to the peak wavelength of the radiation spectrum of the light emitting layer 13 at the maximum operating environment temperature.

In addition, taking into consideration of a change in the output depending on the temperatures of the fluorescent substances 32c and 32d, it is preferable that the following Equation (1) is satisfied.

$$P_{L1} / P_{L2} = (P_{P1} / P_{P2}) \times (P_X / P_Y) \quad - \ - \ - \ (1)$$

Here, $P_{P1}$ is a peak intensity of the radiation spectrum of the fluorescent substance at the room temperature; $P_{P2}$ is a peak intensity of the radiation spectrum of the fluorescent substance at the maximum operating temperature; $P_X$ is the intensity of the excitation spectrum of the fluorescent substance corresponding to the peak wavelength of the radiation spectrum of the light emitting layer 13 at the room temperature; and $P_Y$ is the intensity of the excitation spectrum of the fluorescent substance corresponding to the peak wavelength of the radiation spectrum of the light emitting layer 13 at the maximum operating environment temperature.

As above, the fluorescent substance 32 is selected in the embodiment, so that the change rate of the spectrum intensity of the light emitting layer 13 depending on the temperature coincides with the change rate of the excitation intensity of the fluorescent substance 32 corresponding to the peak wavelength of the radiation spectrum at each temperature. Accordingly, the relation between the intensity of the excitation light and the intensity of the light emitted by the fluorescent substance is maintained to be constant, whereby suppressing the temperature change in the chromaticity.

The fluorescent substances 32c and 32d dispersed in the fluorescent substance layer 30, for example, include a fluorescent substance that emits yellow fluorescence or a fluorescent substance that emits red fluorescence, and a fluorescent substance that emits green fluorescence.

As examples of a fluorescent substance that emits yellow fluorescence, there are materials represented by the following chemical formulas.

$Li (Eu, Sm) W_2O_8$,

$(Y, Gd)_3 (Al, Ga)_5O_{12}$,

$Li_2SrSiO_4 : Eu^{2+}$,

$(Sr (Ca, Ba)_3SiO_5 : Eu^{2+}$

$SrSi_2ON_{2.7} : Eu^{2+}$

As examples of a fluorescent substance that emits red fluorescence, there are materials represented by the following chemical formulas.

$La_2O_2S : Eu, Sm$,

$LaSi_3N_5 : Eu^{2+}$

$\alpha$- sialon : $Eu^{2+}$,

$CaAlSiN_3 : Eu^{2+}$,

$(SrCa) AlSiN_3 : Eu^{X+}$,

$Sr_x (SiyAl_3)_z (O_xN) : Eu^{X+}$

As examples of a fluorescent substance that emits green fluorescence, there are materials represented by the following chemical formulas.

$Al_5Lu_3O_{12} : Ce$,

$(Ba, Sr, Mg) O·aAl_2O_3 : Mn$,

$(BaSr) SiO_4 : Eu$,

$\alpha$- sialon : $Yb^{2+}$

$\beta$- sialon : $Eu^{2+}$

$(CaSr) Si_2O_4N_7: Eu^{2+}$,

$Sr (SiAl) (ON) : Ce$

In addition, the above fluorescent substances are not described for the purpose of limitation, and these materials may be substituted with other materials.

For example, when the peak wavelength of the radiation spectrum of the light emitting layer 13 in a room-temperature operation is in the range of 430 to 480 nm, at least one of the above-described fluorescent substance materials may be used as the fluorescent substance 32d. In other words, taking into consideration of the dependency of the peak wavelength of the radiation spectrum of the light emitting layer 13 on the temperature, a fluorescent substance of which the peak wavelength of the excitation spectrum at the room temperature is shorter than the peak wavelength of the radiation spectrum of the light emitting layer 13 and the ratio $P_{X4}/P_{Y4}$ coincides with the ratio $P_{L1}/P_{L2}$ of the light emitting layer 13 may be selected from among the above-described fluorescent substances. In addition, more preferably, the fluorescent substance is selected according to Equation (1) and taking into consideration of the change in the radiation spectrum of the fluorescent substance depending on the temperature.

Accordingly, the change ratio of the peak intensity of the radiation spectrum of the light emitting layer 13 and the change ratio of the excitation intensity of the fluorescent substance 32 corresponding to the peak wavelength of the radiation spectrum at each temperature may coincide with each other in the temperature range 20°C to 140°C.

Furthermore, a fluorescent substance of which the peak wavelength of the excitation spectrum and the peak wavelength of the radiation spectrum of the light emitting layer 13 in a room- temperature operation coincide with each other can be selected as the fluorescent substance 32c. Thereby, the change ratio of the peak intensity of the radiation spectrum of the light emitting layer 13 and the change ratio of the excitation intensity of the fluorescent substance 32 corresponding to the peak wavelength of the radiation spectrum at each temperature may coincide with each other in the temperature of 20°C to 140°C.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

**Claims**

1. A semiconductor light emitting device comprising:

   a semiconductor layer (15) including a light emitting layer(13); and
   a fluorescent substance (32) excited by light emitted from the light emitting layer (13), a peak wavelength of a radiation spectrum of the light emitting layer (13) at a room temperature being shorter than a peak wavelength of an excitation spectrum of the fluorescent substance (32).

2. The device according to claim 1, wherein the peak wavelength of the radiation spectrum at a maximum temperature in an operating environment is shorter than the peak wavelength of the excitation spectrum.

3. The device according to claim 1, wherein the peak wavelength of the radiation spectrum at the maximum temperature in the operating environment coincides with the peak wavelength of the excitation spectrum.

4. The device according to any of claims 1 to 3, wherein the peak wavelength of the radiation spectrum is shorter than 480 nm.

5. The device according to any of claims 1 to 4, wherein the peak wavelength of the radiation spectrum under constant-current operation is shifted to a longer wavelength side in accordance with a temperature rise in the operating environment.

6. The device according to any of claims 1 to 5, further comprising:

a fluorescent substance layer (30) provided on a first face of the semiconductor layer (15); and
a p-side electrode (16) and a n-side electrode (17) provided on a second face of the semiconductor layer (15) on a side opposite to the first face,
wherein the semiconductor layer (15) has a first region including the light emitting layer (13) and a second region not including the light emitting layer (13) on the second face side; the p-side electrode (16) is provided on the first region; the n-side electrode (17) is provided on the second region; and the fluorescent substance layer (30) includes a transparent resin (31) and the fluorescent substance (32) dispersed in the transparent resin.

7. The device according to claim 6, wherein concavo-convex is provided on the first face, and the fluorescent substance layer (30) covers the concavo-convex.

8. The device according to claims 6 or 7, further comprising:

a first insulating film (18) provided on a side of the second face, the first insulating film (18) including a first opening (18a) communicating with the p-side electrode (16) and a second opening (18b) communicating with the n-side electrode (17);
a p-side interconnection (19, 21, 23) provided on the first insulating film (18) and electrically connected to the p-side electrode (16) through the first opening (18a); and
an n-side interconnection (19, 22, 24) provided on the first insulating film (18) and electrically connected to the n-side electrode (17) through the second opening (18b).

9. The device according to claim 8, further comprising a second insulating film (25) provided between the p-side interconnection (19, 21, 23) and the n-side interconnection (19, 22, 24).

10. The device according to claim 9, wherein the second insulating film (25) covers a periphery of the p-side interconnection (19, 21, 23) and a periphery of the n-side interconnection (19, 22, 24).

11. The device according to claims 9 or 10, wherein
the p-side interconnection (19, 21, 23) includes a p-side interconnection layer (21) provided both inside the first opening (18b) and on the first insulating film (18), and a p-side metal pillar (23) provided on the p-side interconnection layer (21), the p-side metal pillar (23) being thicker than the p-side interconnection layer (21); and
the n-side interconnection (19, 22, 24) includes an n-side interconnection layer (22) provided both inside the second opening (18b) and on the first insulating film (18), and an n-side metal pillar (24) provided on the n-side interconnection layer (22), the n-side metal pillar (24) being thicker than the n-side interconnection layer (22).

FIG. 1

FIG. 2

FIG. 3

FIG. 4A

FIG. 4B

EP 2 657 997 A2

FIG. 5A

15a  10

11  12  13  15b

15

FIG. 5B

12  15b

FIG. 6A

FIG. 6B

FIG. 7A

FIG. 7B

FIG. 8A

FIG. 8B

FIG. 9A

10

17    16    80    18a  18a    18b  18    11  12  13    80
                     18a                      15
                                       10

FIG. 9B

10

17    16          18a  18a    18b  18    11  12  13    19
                     18a                      15
                                       10

FIG. 9C

10

91    17    91    16    91        91    18    91        91    11 12 13    91        91    91
                                            19              15

EP 2 657 997 A2

EP 2 657 997 A2

FIG. 10A

FIG. 10B

23

EP 2 657 997 A2

FIG. 11A

FIG. 11B

FIG. 12A

18  10  15  11  12  13

17  19  16  23  21  22  92b  92a  23  24
92  24  92  23  21  92  24  92  92  92  92

EP 2 657 997 A2

FIG. 12B

24  23  23  24  24  92  23  23  24

24  23  23  24  24  23  23  24

EP 2 657 997 A2

FIG. 13A

FIG. 13B

FIG. 14A

FIG. 14B

EP 2 657 997 A2

EP 2 657 997 A2

FIG. 15A

FIG. 15B

FIG. 16A

FIG. 16B

FIG. 17

FIG. 18

FIG. 19A

FIG. 19B

FIG. 19C

FIG. 20

FIG. 21A

FIG. 21B

FIG. 22

## FIG. 23A

## FIG. 23B